(19) Europäisches Patentamt
European Patent Office
Office européen des brevets

(11) EP 0 755 129 A2

(12) EUROPEAN PATENT APPLICATION

(43) Date of publication:
22.01.1997 Bulletin 1997/04

(51) Int. Cl.[6]: H04B 7/005

(21) Application number: 96108059.5

(22) Date of filing: 21.05.1996

(84) Designated Contracting States:
AT BE CH DE DK ES FR GB IT LI NL SE

(30) Priority: 19.07.1995 US 504021

(71) Applicant: Radio Frequency Systems Inc.
Marlboro, NJ 07746-1899 (US)

(72) Inventor: Meredith, Sheldon Kent
Phoenix, Arizona 85044 (US)

(74) Representative: Pohl, Herbert, Dipl.-Ing et al
Alcatel Alsthom
Intellectual Property Department,
Postfach 30 09 29
70449 Stuttgart (DE)

# (54) Cellular base station amplifiers for amplifying received RF signals

(57) A land mobile radio system (110) includes a plurality of receive antenna (120) for receiving RF signals transmitted from mobile units. Each receive antenna (120) is connected to a transform matrix (133) which divides each received RF signal into a number, N, of transformed signals, each transformed signal containing an equal power level part, 1/N, of each received RF signal. Each transformed signal is provided to an amplifier (135) for amplification thereof, and the amplified transformed signals are provided to an inverse-transform matrix (138) which recombines the equal parts of each amplified transformed signal into amplified received RF signals which are provided to an RF signal processing section (125). The amplified RF signals are thereafter provided to corresponding radio channel units (127).

110
120
120
BPF
BPF
122
122
130
TRANSFORM MATRIX
133
136
135
1
2
135
15
16
135
138
137
INV. TRANSFORM MATRIX
RF SIGNAL PROCESSING
125
RCU #1
RCU #60
127
127
FIG.1

EP 0 755 129 A2

Printed by Rank Xerox (UK) Business Services
2.13.13/3.4

## Description

### Technical Field

The present invention relates to power sharing systems for radio frequency (RF) amplifiers.

### Background of the Invention

Land mobile radio systems must generate power at radio frequencies (RF) in order to communicate with remote mobile stations. Additionally, the land mobile radio system must be capable of receiving RF signals, via receive antennas, from the remote mobile stations.

The receive antennas used to receive RF signals from remote mobile stations are typically located in towers or on top of buildings such that the antennas are generally unobstructed for reliable receipt of RF signals. The signals transmitted from the remote mobile stations are generally very low power, and therefore the signal strength of the RF signals received by the receive antennas is very low. Therefore, the RF signals received by the receive antennas must be amplified prior to processing by receivers of the land mobile radio system.

Because of the very low power level of RF signals received by the receive antennas, it is desirable to amplify these signals as soon as possible after receipt and before transmission via cabling, e.g., coaxial cabling, to a receiver to thereby minimize signal interference and distortion. It is well known in the art to locate amplifiers for amplification of the received RF signals in a tower or at the top of a building as close as possible to the receive antennas. Using such a configuration, the received RF signals may be amplified before any interference or distortion is introduced during transmission via cabling. Alternatively, the receive amplifiers may be located in a more convenient location, such as at the base of an antenna tower. In this case, there is a loss of signal quality due to the losses during transmission.

In known land mobile radio systems, one receive amplifier is provided for each receive antenna. Typically, linear amplifiers are used for amplifying the received RF signals. Linear amplifiers are used because of the vary large dynamic range of the received RF signals. As is apparent to those skilled in the art, the signal strength of received RF signals from a remote mobile station that is close to the receive antennas will be much stronger than the received signal strength of received RF signals transmitted by more distant mobile stations. For example, the average signal strength of received RF signals may be approximately -40dBm, and the for distant mobile stations, the received signal strength may be as low as -122dBm: Therefore, it is important that the amplifiers used in the system have very linear amplification characteristics. If the amplifiers are not highly linear, additional undesired intermodulation signals will be present at the amplifiers output, thereby degrading communication quality.

It is well known to describe the linearity of an amplifier by its "output third order intercept point (IP3O)". For a given set of amplification conditions, the IP3O requirement for an amplifier is given by equation 1 below:

$$IP3O = 15\log P_O - IM/2 + 5\log(N^2 - 3N/2) \qquad \text{(eq. 1)}$$

were: $P_O$ = power output per radio channel in milliwatts; N = number of radio channels being amplified; and IM = maximum allowable intermodulation level (intermodulation distortion) in dBm.

In a typical land mobile radio system, there may be as many as 6 to 12 receive antennas for receiving radio signals from up to 60 channels. A problem exists in determining the size of a receive amplifier in such a land mobile radio system relates to the statistical determination of how many channels (users) will be received simultaneously by any one receive antenna. On average, there might only be 5 users, but it is very possible that as may as 20 users may demand service through a single amplifier at a particular instance in time. In this case, the linearity requirements of the amplifier increase by $5\log(N^2 - 3N/2)$. For example, when increasing the number of users from 5 to 10, the IP3O intercept point increases by over 3 dBm as given by the examples below:

$$5\log(5^2 - 3*5/2) = 6.22 \text{ dBm}$$

$$5\log(10^2 - 3*10/2) = 9.65 \text{ dBm}$$

Therefore, the problem exists of selecting an appropriately sized amplifier to ensure that the amplification requirements for the worst case statistical peaking are met. If the amplifier is undersized, the signal quality of all received RF signals will suffer during amplification.

Another problem associated with such receive amplifiers is reliability. Since each receive antenna is associated with one amplifier, the antenna is rendered useless upon failure of the associated amplifier. This may result in an interruption of service in a sector (geographic area) associated with the beam of the corresponding antenna.

## Disclosure of the Invention

An object of the present invention is to provide an amplifier power sharing system for evenly distributing a plurality of input signals over the amplifiers of the system, and for thereafter recovering the amplified input signals.

Another object of the present invention is to provide a power sharing system which eliminates statistical peaking of the number of signals being amplified by any one amplifier.

A still further object of the present invention is to provide such a power sharing system wherein all of the input signal are amplified, even upon failure of one or more of the amplifiers in the power sharing system.

Another object of the present invention is to provide such a power sharing system for use in a land mobile radio system.

A further object of the present invention is to provide a land mobile radio system having reduced hardware cost, improved reliability and improved signal quality due to improved amplifier characteristics.

According to the present invention, a plurality of input signals are provided to a transform matrix which divides each input signal into a number, N, of transformed signals, each transformed signal containing an equal part, 1/N, of the power of each input signal; each transformed signal is provided to an amplifier for amplification thereof; and the amplified transformed signals are provided to an inverse-transform matrix which recombines the parts of each amplified transformed signal into amplified input signals.

In further accord with the present invention, the amplified input signals are amplified replicas of the input signals.

According further to the present invention, in a land mobile radio system having a plurality of receive antennas, the input signals are provided by the outputs of receive antennas, and the amplified input signals are thereafter provided to receivers.

In still further accord with the present invention, the transform matrix is a Fourier transform matrix and the inverse-transform matrix is an inverse-Fourier transform matrix.

According still further to the present invention, the land mobile radio system includes N antennas, and where N is a power of m, e.g., $N = m^r$, then the transform matrix is a Fourier transform matrix using a radix-m decimation-in-frequency algorithm having r stages, and the inverse-transform matrix in an inverse-Fourier transform matrix using a radix-m decimation-in-time algorithm having r stages.

The present invention provides a significant improvement over the prior art because a land mobile radio system may be provided having improved reliability of the amplification of received signals. All of the received signals are amplified, even upon failure of a receive amplifier. Using the system of the present invention, each amplifier is equally used by all receive antennas. Therefore, the problems associated with statistical peaking are eliminated.

The foregoing and other objects, features and advantages of the present invention will become more apparent in light of the following detailed description of exemplary embodiments thereof as illustrated in the accompanying drawings.

## Brief Description of the Drawings

Fig. 1 is a schematic block diagram of a land mobile radio system having power sharing in accordance with the present invention;

Fig. 2 is a diagram showing the operation of a Fourier transform matrix and an inverse-Fourier transform matrix in relation to 16 linear power amplifiers of the system of Fig. 1, the Fourier transform matrix using a radix-2 decimation-in-frequency algorithm having four stages and the inverse-Fourier transform matrix using a radix-2 decimation-in-time algorithm having four stages;

Fig. 3 is a diagram of a ninety degree hybrid splitter used in the Fourier transform matrix and inverse-Fourier transform matrix of Fig. 2;

Fig. 4 is a diagram showing an alternative embodiment of a ninety degree hybrid splitter of the Fourier transform matrix of Fig. 2; and

Fig. 5 is a diagram showing an alternative embodiment of a ninety degree hybrid splitter of the inverse-Fourier transform matrix of Fig. 2.

## Best Mode for Carrying Out the Invention

The power sharing system of the present invention is particularly well suited for use in a land mobile radio system wherein the statistical peaking of the number of channels (users) received by any amplifier associated with a receive antenna of the system is eliminated because of the equal distribution of received RF signals (input signals) across each of the system amplifiers. Therefore, the required size of each system amplifier is minimized, but fully and uniformly utilized, thereby reducing hardware costs and improving reliability. Additionally, the system of the present invention provides improved reliability because, upon failure of any one amplifier, all of the received RF signals are amplified by the remaining amplifiers.

The present invention implements the principles of a power sharing system designed for use with RF signals provided by radio channel units and amplified in high power linear amplifiers, the system being described in commonly owned, copending U.S. Patent Application No. 08/314,898 filed on September 29, 1994, the disclosure of which is incorporated herein by reference.

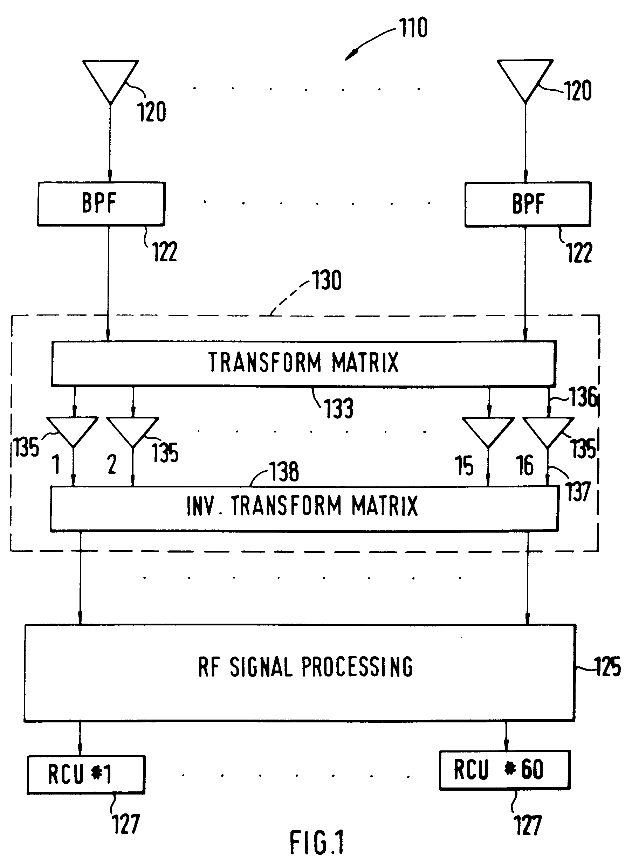

Referring to Fig. 1, a land mobile radio system 110 includes a plurality of receive antenna 120 for receiving RF signals transmitted from mobile stations (not shown). The received RF signals are filtered in band pass filters (BPF) 122, and then provided to an RF signal processing section 125 via the power sharing system 130 of the present invention. The RF signal processing section 125 includes splitters, router, switching, signal processing and any other appropriate equipment for providing each received RF signal to an appropriate radio channel unit 127. Each radio channel unit 127 is a "channel". The system 110 may be used with a large number of channels, e.g., 60 channels.

The power sharing system 130 includes an N x N Fourier transform matrix (Fast-Fourier transform matrix) 133 which receives the outputs of the band pass filters 122, and provides transformed output signals to each of a plurality of linear power amplifiers 135. The outputs of the linear power amplifiers 135 are provided to an N x N inverse-Fourier transform matrix (inverse-Fast-Fourier transform matrix) 138. In the example of the present invention, there are sixteen (16) linear power amplifiers 135. Both the Fourier transform matrix 133 and the inverse-Fourier transform matrix 138 are 16 x 16 matrices. However, as will be understood by those skilled in the art, any number of linear power amplifiers 135 may be used, as described hereinafter. Using the 16 x 16 matrices described herein with respect to the invention, RF signals from up to 16 receive antennas 120 may be amplifier using the power sharing system 130.

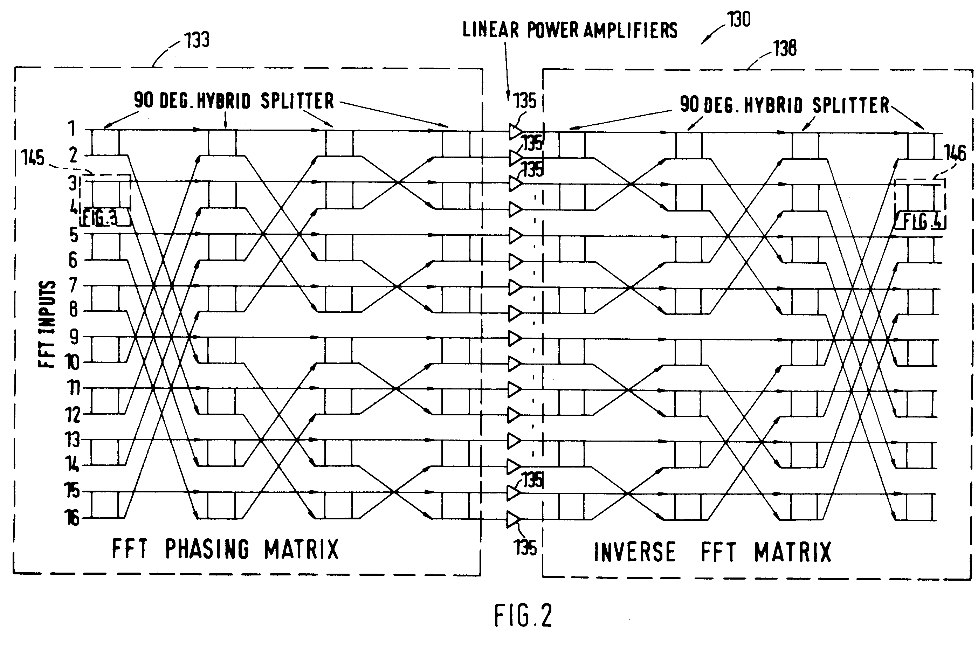

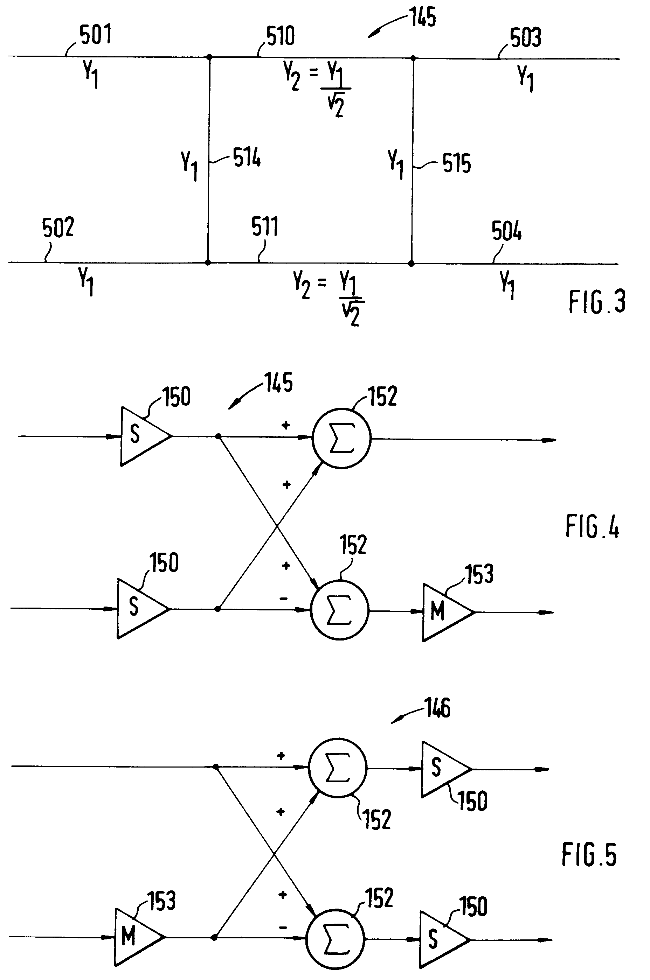

Referring also to Fig. 2, the power sharing system 130 is shown in greater detail. The Fourier transform matrix 133 evenly spreads the outputs of the band pass filters 122 over the 16 linear power amplifiers 135. This is accomplished by using a radix-2 decimation-in-frequency algorithm having four stages. A radix-2 decimation-in-frequency algorithm is described in greater detail on pages 28 through 30 and figures 8 through 14 of *Kraniauskas, Peter*, "A Plain Man's Guide to the FFT", IEEE Signal Processing Magazine, Pages 24-35, April 1994, the disclosure of which is incorporated herein by reference. As will be understood by those skilled in the art, each stage of a radix-2 decimation-in-frequency algorithm includes a plurality of ninety degree hybrid splitters 145, which are shown in greater detail in Fig. 3.

Referring to Fig. 3, each ninety degree hybrid splitter 145 may be a symmetrical four-port branch line coupler of the type known in the art. In the first stage of the Fourier transform matrix, outputs from two of the 16 lossy combiners are coupled to the splitter by a pair of input ports (lines) 501,502 having an identical characteristic impedance, $Y_1$, e.g., 50Ω. The outputs from the splitter are provided on a pair of output ports (lines) 503,504. The output ports 503,504 have the same characteristic impedance, $Y_1$, as the input ports 501,502. The input ports 501,502 are connected to the output ports 503,504 by a pair of primary lines 510,511. Additionally, the input ports 501,502 and the output ports 503,504 are shunt connected by a pair of secondary lines (branch lines) 514,515. The length and impedance of the primary lines 510,511 and secondary lines 514,515 is selected to provide the desired division ratio of the input signals to the output signals.

To implement the desired ninety degree hybrid splitter of the present invention, the characteristic impedance, $Y_2$, of the primary lines 510,511 is selected to be equal to the characteristic impedance of the input and output ports times $2^{-1/2}$, i.e., $Y_2 = (Y_1)(2^{-1/2}) = .707Y_1$. The characteristic impedance of the secondary lines is the same as the characteristic impedance of the input and output ports, i.e., $Y_1$. The length of the primary lines and secondary lines is selected to be one-quarter (1/4) wavelength of the input signals. The phase velocity of the signals in the primary lines and secondary lines will be different because of the different characteristic impedance of the lines, and therefore, lines of different lengths must be used to provide the one-quarter wavelength length.

The hybrid splitter 145 may also be implemented using a "decimation-in-frequency butterfly" as illustrated in Fig. 4. Referring to Fig. 4, a decimation-in-frequency butterfly includes scaling functions 150, algebraic functions 152 and multipliers 153 known as "twiddle factors". The scaling factors 150 are not required at every decimation stage, and can be collected to be applied only once, either to the input sequence or the output sequence of the Fourier transform matrix 133. As is known in the art, each of the splitters 145 shifts its input by 1/2 of its period, in this case ninety degrees. The output of a decimation stage can be interpreted as two half-length sequences of the input of the stage. Therefore, by recursively applying the decimation process over four stages, each one of the 16 lossy combiner output signals is spread out evenly over the 16 matrix outputs, e.g., $2^4 = 16$, so that each amplifier amplifies one-sixteenth of each channel.

As shown in both Figs. 1 and 2, the outputs of the Fourier transform matrix 133 are provided as the inputs to each power amplifier 135. In this case, using the Fourier transform matrix described hereinabove, each amplifier is used by all received RF signals at a low power per channel. Therefore, even if all channels are active simultaneously, the maximum power ever required by any one amplifier is just 1/N(1/16th) of the total power for all channels. In a system 110 having 60 channels, this gives an effective peak power requirement for each amplifier equal to that for less than 4 (60 ÷ 16 = 3.75) channels. Therefore, no statistical peaking allowance is required with the amplification system of the present invention. Additionally, in prior art systems, if one of the amplifiers fails, no received RF signals received from the corresponding receive antenna 120 are amplified. In contrast, using the power sharing system of the present invention, if one of the amplifiers fails, all of the RF signals are still amplified by the remaining operating amplifiers. Therefore, the maintenance problems associated with the amplifiers are greatly reduced. There is no need to urgently replace or repair a filed amplifier because all of the RF signals are amplified by the remaining amplifiers.

After amplification of the distributed received RF signals, the original received RF signals are reconstructed by the inverse-Fourier transform matrix 138. The inverse-Fourier transform matrix utilizes a radix-2 decimation-in-time algorithm having four stages to convert the outputs of the 16 amplifiers into amplified replicas of the received RF signals. The operation of the radix-2 decimation-in-time algorithm is described on pages 31 through 32 and figures 15 through 19 of the above referenced *Kraniauskas* article, the disclosure of which is incorporate herein by reference. A ninety degree hybrid splitter 146, of the type shown in Fig. 3 and described hereinabove, is used in the radix-2 decimation-in-time algorithm. Alternatively, a "decimation-in-time butterfly" of the type shown in Fig. 5 may be used to implement the inverse-Fourier transform matrix. The decimation-in-time butterfly 146 is basically the inverse of the decimation-in-frequency butterfly 145 (Fig. 4). Each stage combines corresponding half-length sequences, starting with the final decimation stage, and back-propagates the arguments towards the input stage. As mentioned above, the final outputs are amplified replicas of the received RF signals. Thereafter, the outputs of the inverse-Fourier transform matrix are provided to the RF signal processing section 125 (Fig. 1).

As discussed herein above, each splitter 145 in the Fourier transform matrix introduces a ninety degree phase shift to the input of the splitter for producing two half-length sequences of the splitter input. Similarly, in the inverse-Fourier transform matrix, each splitter combines two half-length sequences into an original parent sequence. If, either during amplification of the outputs of the Fourier transform matrix or during transmission of the input and output of the amplifiers 135 on signal lines 136 and 137, different phase shifts are introduced into the signals, the signals may be improperly reconstructed in the inverse-Fourier transform matrix. Therefore, it is important that the signal lines 136,137 and amplifiers 135 be phase-balanced with respect to one another so that each signal experiences an identical phase shift during amplification and transmission between the Fourier transform matrix and inverse-Fourier transform matrix. The phase-balancing may be accomplished by controlling the lengths of the signal lines 136, 137, and/or by-adjusting the phase shift introduced by the amplifiers 135.

Although the preferred embodiment of the present invention is illustrated with a radix-2 Fast-Fourier Transform (FFT) having four stages, it will be understood by those skilled in the art that a variety of radices may be used in the Fourier transform matrix 133 (Fig. 1) and in the inverse-Fourier transform matrix 138 (Fig. 2) for implementing the present invention. For a given number of antennas and associated amplifiers, N, where N is a power of m, i.e., $N = m^r$, then the Fourier transform matrix uses a radix-m decimation-in-frequency algorithm having r stages and the inverse-Fourier transform matrix uses a radix-m decimation-in-time algorithm having r stages. In the example given above, N is 16 and m is 2, and therefore there are four stages, i.e., r = 4. However, if a radix-4 decimation-in-frequency algorithm is used, only two stages are required. As will be understood by those skilled in the art, depending on the number of amplifiers used in the system, other radices and associated number of stages may be selected to meet the requirements of the implementation. Examples of radix-3 and radix-4 radices are provided on pages 32 - 35 of the above referenced *Kraniauskas* article, the disclosure of which is incorporated herein by reference.

The power sharing system is described herein as being used in a land mobile radio system. However, the principles of the present invention may be applied to any system where a number of signals are to be amplified by a plurality of amplifiers and presented at a given output (antenna or receiver for instance).

It will be understood by those skilled in the art that the terms "Fourier" and "Fast-Fourier" are used interchangeably throughout the above description. The operating principles of the present invention are equably applicable to a power sharing system using either type of transform matrix. It will be further understood by those skilled in the art the other types of matrix implementations may be used provided that the desired power sharing and phase shifting is accomplished. For example, it is expected that the present invention can be implemented using a Butler transform matrix.

Although the invention has been described and illustrated with respect to exemplary embodiments thereof, it should be understood by those skilled in the art that the foregoing and various other omissions and additions may be made therein and thereto without departing from the spirit and scope of the present invention.

## Claims

**1.** A power sharing system for amplifying a plurality of input signals, comprising:

a plurality of amplification means;

transform matrix means responsive to said plurality of input signals for providing transformed signals, each one of said transformed signals containing a portion of each one of said plurality of input signals, each one of said transformed signals being provided to a corresponding one of said amplification means for providing amplified transformed signals; and

inverse-transform matrix means responsive to said amplified transformed signals for providing amplified input signals, each one of said amplified input signals corresponding to one of said plurality of said input signals.

**2.** A power sharing system according to claim 1 wherein said transform matrix means is a Fourier transform matrix and said inverse-transform matrix means is an inverse-Fourier transform matrix.

**3.** A power sharing system according to claim 2 wherein:

the power sharing system comprises a number, N, of said amplification means,

where N is a power, r, of m as given by the relationship

$$N = m^r$$

said Fourier transform matrix is implemented using a radix-m decimation-in-frequency algorithm having r stages, and

said inverse-Fourier transform matrix is implemented using a radix-m decimation-in-time algorithm having r stages.

**4.** A power sharing system according to claim 1 wherein:

the power sharing system comprises a number, N, of said amplification means,

where N is a power, r, of m as given by the relationship

$$N = m^r$$

said transform matrix means is a Fourier transform matrix using a radix-m decimation-in-frequency algorithm having r stages, and

said inverse-transform matrix means is an inverse-Fourier transform matrix using a radix-m decimation-in-time algorithm having r stages.

**5.** A power sharing system according to claim 4, further comprising a plurality of receive antenna for receiving radio signals, and for providing said radio signals as said input signals.

**6.** A power sharing system according to claim 5, wherein each one of said transformed signals contains a portion, 1/N, of each radio signal.

**7.** A power sharing system according to claim 1, wherein each one of said amplification means are phase balanced with respect to one another such that each one of said amplified transformed signals experiences an identical phase shift during amplification by said amplification means.

**8.** A power sharing system according to claim 1 wherein said transform matrix means is a Fast-Fourier transform matrix and said inverse-transform matrix means is an inverse-Fast-Fourier transform matrix.

**9.** A power sharing system according to claim 2 wherein:

the power sharing system comprises a number, N, of said amplification means,

where N is a power, r, of m as given by the relationship

$$N = m^r$$

said Fast-Fourier transform matrix is implemented using a radix-m decimation-in-frequency algorithm having r stages, and

said inverse-Fast-Fourier transform matrix is implemented using a radix-m decimation-in-time algorithm hav-

ing r stages.

110
120
120
BPF
BPF
122
122
130
TRANSFORM MATRIX
133
136
135
135
135
1
2
15
16
138
137
INV. TRANSFORM MATRIX
RF SIGNAL PROCESSING
125
RCU #1
RCU #60
127
127

FIG.1

133
LINEAR POWER AMPLIFIERS
130
138
90 DEG. HYBRID SPLITTER
90 DEG. HYBRID SPLITTER
135
145
146
FIG. 3
FIG. 4
FFT INPUTS
1
2
3
4
5
6
7
8
9
10
11
12
13
14
15
16
FFT PHASING MATRIX
INVERSE FFT MATRIX

FIG. 2

145
501
510
503
$Y_1$
$Y_2 = \frac{Y_1}{\sqrt{2}}$
$Y_1$
$Y_1$
514
$Y_1$
515
502
511
504
$Y_1$
$Y_2 = \frac{Y_1}{\sqrt{2}}$
$Y_1$
145
150
152
S
+
+
150
152
+
-
S
153
M
146
+
S
+
150
152
153
+
152
150
M
-
S
FIG.3

FIG.4

FIG.5